Europäisches Patentamt

European Patent Office

Office européen des brevets

(11) Publication number: **0 054 764**
**B1**

(12) EUROPEAN PATENT SPECIFICATION

(45) Date of publication of patent specification: **16.09.87**

(51) Int. Cl.⁴: **H 01 L 29/86**, H 01 L 21/268

(21) Application number: **81110017.1**

(22) Date of filing: **30.11.81**

(54) **A method of trimming the resistance of a semiconductor resistor device.**

(30) Priority: **23.12.80 JP 181320/80**

(43) Date of publication of application:
**30.06.82 Bulletin 82/26**

(45) Publication of the grant of the patent:
**16.09.87 Bulletin 87/38**

(84) Designated Contracting States:
**DE FR GB**

(56) References cited:
**DE-A-2 837 315**
**DE-A-2 849 716**
**US-A-4 179 310**

**IBM TECHNICAL DISCLOSURE BULLETIN, vol.
17, no. 10, March 1975, page 2878, New York
(USA); J.A.PARISI: "Integrated resistor
trimming"**

**IBM TECHNICAL DISCLOSURE BULLETIN, vol.
21, no. 8, January 1979, pages 3271-3272, New
York (USA); B.K.AGGARWAL: "Laser-
programmable variable-value resistor"**

(73) Proprietor: **Kabushiki Kaisha Toshiba
72, Horikawa-cho Saiwai-ku
Kawasaki-shi Kanagawa-ken 210 (JP)**

(72) Inventor: **Komatsu, Shigeru
3-4-206, Iijima-danchi 527 Iijima-cho
Totsuka-ku Yokohama-shi (JP)**

(74) Representative: **Kador . Klunker . Schmitt-Nilson
. Hirsch
Corneliusstrasse 15
D-8000 München 5 (DE)**

(56) References cited:
**IBM TECHNICAL DISCLOSURE BULLETIN, vol.
21, no. 3, August 1978, pages 1124-1125, New
York (USA); B.K.AGGARWAL: "Laser
personalizable resistors"**

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

Courier Press, Leamington Spa, England.

EP 0 054 764 B1

# Description

This invention relates to a method of trimming the resistance of a semiconductor resistor device including a semiconductor resistor region formed in or over the surface area of a semiconductor substrate and conductive electrodes ohmically contacting the surface of the resistor region.

With a digital-analog converter or analog-digital converter, a precise resistance value generally determines the reliability of the converter circuit. Therefore, a resistor of high precision is required for such converter. However, a thin resistor device of the hybrid type proposed to date for this object has the drawbacks that the resistor device has a low moisture proof property and is manufactured by a complicated process. On the other hand, a diffusion type resistor or polycrystalline silicon resistor manufactured during the conventional semiconductor-manufacturing process must be allowed to have variations of at least about 0.4% in resistance value in consideration of deviations occurring in the factors involved in the conventional semiconductor device-manufacturing process. Yet, the above-mentioned type of resistor has the advantage that it can be easily manufactured at low cost. At present, therefore, this type of resistor is still put to practical application by trimming its resistance value. One of the known resistor-trimming processes comprises connecting a plurality of diffusion type resistors in parallel by electrode metals of, for example, aluminum, and cutting the intervening electrode metals by laser beams, thereby raising the resistance of the portion including all the diffusion type resistors to a prescribed level. Another known resistor-trimming process comprises destroying part of a polycrystalline silicon resistor by laser beams. However, the above-mentioned conventional resistor-trimming processes destroy part of an electrode metal or semiconductor device by high output laser beams, presenting difficulties in assuring the reliability of a resistor device as a whole, and further imposing certain limitations on the construction of the resistor device. A method according to the first paragraph of the description is known from IBM Technical Disclosure Bulletin Vol. 21 No. 3 August 1978, pages 1124—1125. It comprises a first resistor electrode and a second resistor electrode. The second resistor electrode contacts the semiconductor resistor region at seven separate positions spaced along the semiconductor resistor region. The effective resistance between the first resistor electrode and the second resistor electrode can be increased by severing a part of the second resistor electrode by a laser pulse. The portion of the semiconductor resistor region being below the severed part of the second resistor electrode, is no more bridged by the second resistor electrode and contributes to the overall resistance. This known method allows the effective resistance to be adjusted by the laser severing process. However, since the second resistor electrode contacts the semiconductor resistor region only at discrete intervals, the effective resistance can be trimmed only in corresponding steps of resistance.

It is accordingly the object of this invention to provide a semiconductor device of high reliability whose resistance value can be trimmed with a high precision.

This object also can be attained by a step of irradiating a laser beam onto at least one trimming electrode to effect alloying between the beam-irradiated electrode and the resistor region, thereby reducing the resistance of the resistor region.

This object can be attained by a step of irradiating a laser beam onto at least one resistor electrode thereby reducing the resistance of the resistor region due to alloying.

The method according to the present invention can be carried out with low power laser pulses. The alloyed region between the beam-irradiated electrode and the resistor region can be adjusted finely so that the method according to the present invention allows a very precise trimming of the resistor device.

The beam-irradiated electrode can be one of the resistor electrodes or a metal layer formed between the resistor electrodes and ohmically contacting the surface of the resistor region.

This invention can be more fully understood from the following detailed description when taken in conjunction with the accompanying drawings, in which:

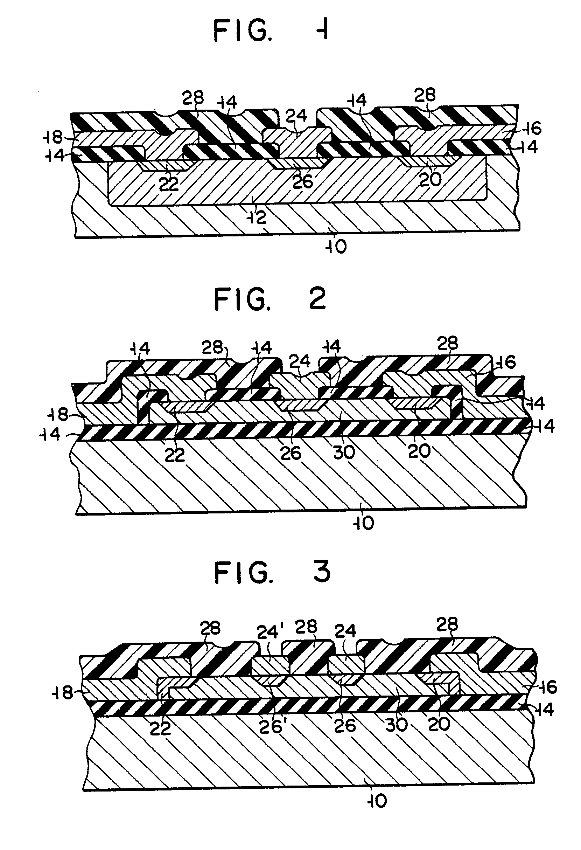

Figs. 1 to 3 are the sectional views of semiconductor resistor devices according to different embodiments of this invention.

Description is now given with reference to Fig. 1 of a semiconductor resistor device according to a first embodiment of this invention. Referring to Fig. 1, a P-type silicon resistor region 12 is diffused in the surface area of an N-type silicon substrate 10. A silicon oxidized ($SiO_2$) layer 14 is deposited on the surfaces of the substrate 10 and resistor region 12. The resistor region 12 generally has a rectangular surface. Two holes are formed in the $SiO_2$ layer 14 mounted on both end portions of the resistor region 12, respectively. Aluminum or aluminum alloy electrodes 16 and 18 used as resistor electrodes are respectively ohmically contacted to the both end portions of the resistor region 12 through the corresponding holes. This ohmic contact cause alloy layers 20 and 22 to be respectively formed in the corresponding junctions between the resistor region 12 and resistor electrodes 16 and 18. A hole is also formed in the oxidized layer 14 mounted on the upper part of the central portion of the resistor region 12. A trimming electrode 24 formed of a metal alloying with silicon like the resistor electrode is ohmically contacted to the resistor region 12 through the hole. An alloy layer 26 is also produced in the junction between the trimming electrode 24 and resistance region 12. The trimming electrode 24 is formed of a metal selected from the group consisting of aluminum, aluminum alloy, platinum, titanium, etc. A protective layer 28 is coated on the surfaces of the oxidized layer 14, resistor electrodes 16 and 18 and trimming electrode 24. The protective layer 28 is produced by the chemical vapor deposition (CVD) of $SiO_2$ or application of polyimide. A hole is formed in that portion of the protective layer 28 which is positioned on the trimming electrode 24.

Where, after the above-mentioned construction of the resistor device, laser beams are emitted to the trimming electrode 24 through the hole of the protective layer 28, then alloying between the trimming electrode 24 and resistor region 12 proceeds to enlarge the alloy layer 26. The enlargement of the alloy layer 26 decreases the resistance of the resistance region 12. If, therefore, laser pulses are emitted to the trimming electrode 24 for the growth of the alloy layer 26, while measuring the resistance of the resistance region 12, then it is possible to obtain a desired level of resistance. The laser pulses which are simply intended to effect alloying between the semiconductor resistor and trimming electrode instead of destroying the semiconductor resistor, thereby, they only produce a low output (for example, about 500°C). The hole of the protective layer 28 is intended to assure the effective transmission of the laser pulses to the trimming electrode 24 and prevent the protective layer from being damaged by the heat of the laser pulses. If the power level of the laser pulses is extremely low, then the resistor device can be trimmed to an extent of several ohms. With the above-mentioned embodiment, resistance can be trimmed downward. Where, therefore, trimming is carried out of a resistor circuit which is damaged to have the so-called pair characteristic, it is advised to trim the resistance values of the resistor circuit to a minimum level thereof.

The aforementioned embodiment can trim the resistance of a semiconductor resistor device by alloying a semiconductor, instead of destroying part thereof, thereby providing a semiconductor resistor device of high precision and high reliability.

Description is now given of a semiconductor resistor device according to a second embodiment of this invention. The parts of the second embodiment the same as those of the first embodiment are denoted by the same numerals, description thereof being omitted. The second embodiment of Fig. 2 is different from the first embodiment only in that the resistor is not produced by diffusion, but is formed by depositing an impurity-doped polycrystalline silicon layer 30 on the insulating layer 14 mounted on the semiconductor substrate 10.

A semiconductor resistor device of Fig. 3 according to a third embodiment of the invention is different from the second embodiment of Fig. 2 in that no insulation layer 14 is provided between the polycrystalline silicon layer 30 and the resistor electrode 16, as well as between the polycrystalline silicon layer 30 and the resistor electrode 18, and that two trimming electrodes 24 and 24' are provided. Not only with the diffusion type resistor, but also with the polycrystalline silicon resistor, alloying can accurately trim the resistance of the resistor device. As in the third embodiment of Fig. 3, it is possible to provide a plurality of trimming electrodes.

The resistance can be trimmed by directly emitting laser pulses to the resistor electrodes 16 and 18 without providing a trimming electrode.

**Claims**

1. A method of trimming the resistance of a semiconductor resistor device including a semiconductor resistor region (12, 30) formed in or over the surface area of a semiconductor substrate (10) and conductive electrodes forming the resistor electrodes (16, 18 and the trimming electrodes 24, 24') ohmically contacting the surface of the resistor region, characterized by comprising a step of irradiating a laser beam onto at least one trimming electrode (24, 24') consisting of a metal alloying ohmically with the resistor region (12) to effect alloying between said beam-irradiated electrode (24, 24') and resistor region (12, 30), thereby reducing the resistance of the resistor region (12, 30).

2. A method of trimming the resistance of a semiconductor resistor device, including a semiconductor resistor region formed in or over the surface area of a semiconductor substrate and conductive electrodes ohmically contacting the surface of the resistor region and forming the resistor electrodes characterized by comprising a step of irradiating a laser beam onto at least one resistor electrode to effect alloying between said beam-irradiated electrode and the resistor region, thereby reducing the resistance of the resistor region.

**Patentansprüche**

1. Verfahren zum Einstellen des Widerstandswertes einer Halbleiterwiderstandsanordnung, die ein Halbleiterwiderstandsbereich (12, 30), der in oder oberhalb des Oberflächenbereiches eines Halbleitersubstrates (10) ausgebildet ist und leitfähige Elektroden, die die Widerstandselektroden (16, 18) bilden und Einstellelektroden (24, 24'), die mit der Oberfläche des Widerstandsbereiches in ohmschem Kontakt stehen, umfaßt, dadurch gekennzeichnet, daß es einen Schritt umfaßt, bei dem ein Laserstrahl auf zumindest eine Einstellelektrode (24, 24') gerichtet wird, die aus einer Metallegierung besteht, die mit dem Widerstandsbereich (12) in ohmschem Kontakt steht, um die Legierungsbildung zwischen der mit dem Laserstrahl bestrahlten Elektrode (24, 24') und dem Widerstandsbereich (12, 30) zu bewirken, um dadurch den Widerstand des Widerstandsbereiches (12, 30) zu verringern.

2. Verfahren zum Einstellen des Widerstandswertes einer Halbleiterwiderstandsanordnung, die ein Halbleiterwiderstandsbereich, der in oder oberhalb des Oberflächenbereiches eines Halbleitersubstrates ausgebildet ist und leitfähige Elektroden umfaßt, die mit der Oberfläche des Widerstandsbereiches in ohmschem Kontakt stehen und die Widerstandselektrode bilden, dadurch gekennzeichnet, daß es eine Stufe umfaßt, bei der ein Laserstrahl auf zumindest eine Widerstandselektrode gerichtet ist, um die Legierungsbildung zwischen der mit dem Laserstrahl bestrahlten Elektrode und dem Widerstandsbereich zu bewirken, um dadurch den Widerstand des Widerstandsbereiches zu verringern.

**Revendications**

1. Procédé d'ajustement de la valeur de résistance d'un dispositif résistant semiconducteur comportant une région résistante semiconductrice (12, 30) formée dans ou sur l'aire superficielle d'un substrat semiconducteur (10) et des électrodes conductrices formant les électrodes (16, 18) de la résistance et les électrodes d'ajustement (24, 24') en contact ohmique avec la surface de la région résistante, caractérisé en ce qu'il comprend l'opération consistant à envoyer un faisceau laser sur au moins une électrode d'ajustement (24, 24') constituée d'un métal s'alliant du point de vue ohmique avec la région résistante (12) pour provoquer l'alliage entre ladite électrode ayant reçu le faisceau (24, 24') et la région de résistance (12, 30), de manière à réduire la valeur de résistance de la région résistante (12, 30).

2. Procédé d'ajustement de la valeur de résistance d'un dispositif résistant semiconducteur comportant une région résistante semiconductrice formée dans ou sur l'aire superficielle d'un substrat semiconducteur et des électrodes conductrices en contact ohmique avec la surface de la région résistante et formant les électrodes de la résistance, caractérisé en ce qu'il comprend l'opération consistant à envoyer un faisceau laser sur au moins une électrode de la résistance afin de provoquer l'alliage entre ladite électrode ayant reçu le faisceau et la région résistante, de manière à réduire la valeur de résistance de la région résistante.

FIG. 1

FIG. 2

FIG. 3

1